(19) Europäisches Patentamt
European Patent Office
Office européen des brevets

(11) EP 3 670 699 A1

(12) **EUROPEAN PATENT APPLICATION**

(43) Date of publication:
24.06.2020 Bulletin 2020/26

(51) Int Cl.:
*C23C 28/04* (2006.01)       *C23C 16/30* (2006.01)
*C23C 16/34* (2006.01)       *C23C 16/36* (2006.01)
*C23C 16/40* (2006.01)       *C23C 28/00* (2006.01)
*C23C 30/00* (2006.01)       *C23C 16/02* (2006.01)

(21) Application number: 18214848.6

(22) Date of filing: 20.12.2018

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **AB Sandvik Coromant
811 81 Sandviken (SE)**

(72) Inventors:
• **ENGQVIST, Jan**
**75218 Uppsala (SE)**
• **SACRISTAN PEREZ, Irantzu**
**11550 Stockholm (SE)**

(74) Representative: **Sandvik
Sandvik Intellectual Property AB
811 81 Sandviken (SE)**

(54) **COATED CUTTING TOOL**

(57)    The present invention relates to a coated cutting tool comprising a substrate and a coating, wherein the coating comprises an inner $\alpha$-Al$_2$O$_3$-multilayer and an outer $\alpha$-Al$_2$O$_3$-single-layer. The thickness of the inner $\alpha$-Al$_2$O$_3$-multilayer is 50% to 80% of the sum of the thickness of the inner $\alpha$-Al$_2$O$_3$-multilayer and the thickness of the outer $\alpha$-Al$_2$O$_3$-single-layer. The sum of the thickness of the inner $\alpha$-Al$_2$O$_3$-multilayer and the outer $\alpha$-Al$_2$O$_3$-single-layer is preferably 2-15 $\mu$m. Said $\alpha$-Al$_2$O$_3$-multilayer consist of alternating sublayers of $\alpha$-Al$_2$O$_3$ and sublayers of TiCO, TiCNO, AlTiCO or AlTiCNO, said $\alpha$-Al$_2$O$_3$-multilayer comprises at least 8 sublayers of $\alpha$-Al$_2$O$_3$.

Fig. 1

EP 3 670 699 A1

**Description**

TECHNICAL FIELD OF THE INVENTION

The present invention relates to a coated cutting tool comprising a substrate and a coating, wherein the coating comprises an inner $\alpha$-Al$_2$O$_3$-multilayer and an outer $\alpha$-Al$_2$O$_3$-single-layer.

BACKGROUND

CVD coatings of aluminum oxide has been shown to be advantageous in metal cutting applications and the major part of the CVD coated turning inserts are today provided with a coating of aluminum oxide. The aluminum oxide coatings have over the years been more and more optimized since it has been shown that changes of for example grain size and crystal orientation of the aluminum oxide crystals in the coating have a large influence on the wear properties during metal cutting.

There is a continuous need of finding cutting tool coatings that can prolong the life time of the cutting tool and/or that can withstand higher cutting speeds than the known cutting tool coatings.

SUMMARY OF THE INVENTION

One object of the present invention is to provide a coated cutting tool with improved resistance to wear in metal cutting applications. A further object is to improve its resistance in turning operations, especially in turning in steel and hardened steel. It is a further object to provide a wear resistant coating that provides a high resistance to flaking of the coating in turning of steel and hardened steel.

At least one of these objects is achieved with a coated cutting tool according to claim 1.

Preferred embodiments are listed in the dependent claims.

The present disclosure relates to a coated cutting tool comprising a substrate and a coating, wherein the coating comprises an inner $\alpha$-Al$_2$O$_3$-multilayer and an outer $\alpha$-Al$_2$O$_3$-single-layer, wherein the thickness of the outer $\alpha$-Al$_2$O$_3$-single-layer is 1-8 $\mu$m, preferably 1-3 $\mu$m, and wherein the thickness of the inner $\alpha$-Al$_2$O$_3$-multilayer is 50% to 80% of the sum of the thickness of the inner $\alpha$-Al$_2$O$_3$-multilayer and the thickness of the outer $\alpha$-Al$_2$O$_3$-single-layer, and wherein said $\alpha$-Al$_2$O$_3$-multilayer consist of alternating sublayers of $\alpha$-Al$_2$O$_3$ and sublayers of TiCO, TiCNO, AlTiCO or AlTiCNO, said inner $\alpha$-Al$_2$O$_3$-multilayer comprises at least 8 sublayers of $\alpha$-Al$_2$O$_3$.

It has surprisingly been found that a maximum in performance exists for a specific combination of $\alpha$-Al$_2$O$_3$-multilayer and $\alpha$-Al$_2$O$_3$-single-layer. This combination provides an increased resistance to flaking. It is believed that the $\alpha$-Al$_2$O$_3$-multilayer is important for the wear resistance when the cutting edge has started to deform due to wear and heat of the cutting edge.

In one embodiment of the present invention the inner $\alpha$-Al$_2$O$_3$-multilayer is adjacent to the outer $\alpha$-Al$_2$O$_3$-single-layer.

In one embodiment of the present invention the sum of the thickness of the inner $\alpha$-Al$_2$O$_3$-multilayer and the outer $\alpha$-Al$_2$O$_3$-single-layer is 2-16 $\mu$m, preferably 3-8 $\mu$m, most preferably 4-6 $\mu$m.

In one embodiment of the present invention a period in the inner $\alpha$-Al$_2$O$_3$-multilayer is 50-900 nm, preferably 70-300 nm, more preferably 70-150 nm, wherein one period is including one sublayer of $\alpha$-Al$_2$O$_3$ and one sublayer of TiCO, TiCNO, AlTiCO or AlTiCNO, preferably TiCO.

In one embodiment of the present invention the thickness of the inner $\alpha$-Al$_2$O$_3$-multilayer is 50% to 80%, preferably 65% to 75%, of the sum of the thickness of the inner $\alpha$-Al$_2$O$_3$-multilayer and the thickness of the outer $\alpha$-Al$_2$O$_3$-single-layer.

In one embodiment of the present invention the inner $\alpha$-Al$_2$O$_3$-multilayer in combination with the outer $\alpha$-Al$_2$O$_3$-single-layer exhibits an XRD diffraction over a $\theta$-2$\theta$ scan of 20°-140°, wherein the intensity of the 0012 diffraction peak (peak area), I(0012), to the intensities of the 113 diffraction peak (peak area), I(113), the 116 diffraction peak (peak area), I(116), and 024 diffraction peak (peak area), I(024), is I(0012)/I(113) > 1, I(0012)/I(116) > 1 and I(0012)/I(024) > 1.

In one embodiment of the present invention the inner $\alpha$-Al$_2$O$_3$-multilayer in combination with the outer $\alpha$-Al$_2$O$_3$-single-layer exhibits an XRD diffraction over a $\theta$-2$\theta$ scan of 20°-140°, wherein the intensity of the 0 0 12 diffraction peak (peak area), I(0012), to the intensities of the 113 diffraction peak (peak area), I(113), the 116 diffraction peak (peak area), I(116), and the 0 2 4 diffraction peak (peak area), I(024), is I(0012)/I(113) > 1, preferably > 5, most preferably > 8, I(0012)/I(116) > 1, preferably > 3, most preferably > 5, and I(0012)/I(024) > 1, preferably > 2.

In one embodiment of the present invention the intensity of the 0114 diffraction peak (peak area), I(0114), to the intensity of the 0012 diffraction peak (peak area), I(0012), is I(0114)/I(0012) < 2, preferably < 1.

In one embodiment of the present invention the relation between the intensity of the 110 diffraction peak (peak area), I(110), and the intensities of the 1 1 3 diffraction peak (peak area), I(113), and the 024 diffraction peak (peak area), I(024), is I(110) > each of I(113) and I(024).

In one embodiment of the present invention the relation between the intensity of the 00 12 diffraction peak (peak area), I(0012), and the intensity of the 110 diffraction peak (peak area), I(110), is I(0012) > I(110).

In one embodiment of the present invention the coated cutting tool comprises at least one layer of TiC, TiN, TiAlN or TiCN located between the substrate and the inner $\alpha$-Al$_2$O$_3$-multilayer, preferably TiCN.

In one embodiment of the present invention the thickness of the TiC, TiN, TiAlN or TiCN layer is 2-15 $\mu$m, preferably 3-13 $\mu$m.

In one embodiment of the present invention the coated cutting tool comprises a TiCN layer that exhibits an X-ray diffraction pattern, as measured using CuK$\alpha$ radiation and $\theta$-2$\theta$ scan, wherein the TC(hkl) is defined according to Harris formula:

$$TC(hkl) = \frac{I(hkl)}{I_0(hkl)} \left[ \frac{1}{n} \sum_{n=1}^{n} \frac{I(hkl)}{I_0(hkl)} \right]^{-1}$$

where I(hkl) is the measured intensity (integrated area) of the (hkl) reflection, I$_0$(hkl) is the standard intensity according to ICDD's PDF-card No. 42-1489, n is the number of reflections, reflections used in the calculation are (111), (200), (220), (311), (331), (42 0), (422) and (511), wherein TC(331)+TC(422) > 5, preferably > 6.

In one embodiment of the present invention the outermost layer of the coating is said outer $\alpha$-single-Al$_2$O$_3$ layer.

In one embodiment of the present invention the substrate is of cemented carbide, cermet, ceramic, high speed steel or cBN.

In one embodiment of the present invention the substrate is of cemented carbide comprising 3-14 wt% Co and more than 50 wt% WC.

The coated cutting tools described herein can be subjected to post-treatments such as blasting, brushing or shot peening in any combination. A blasting post-treatment can be wet blasting or dry blasting for example using alumina particles.

Still other objects and features of the present invention will become apparent from the following definitions and examples considered in conjunction with the accompanying drawings.

BRIEF DESCRIPTION OF DRAWINGS

In the drawings:

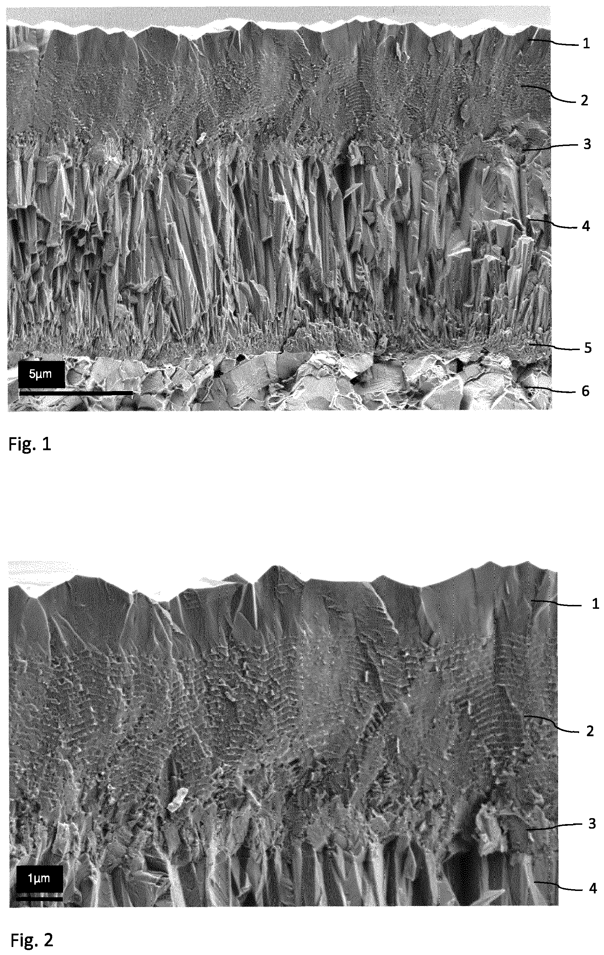

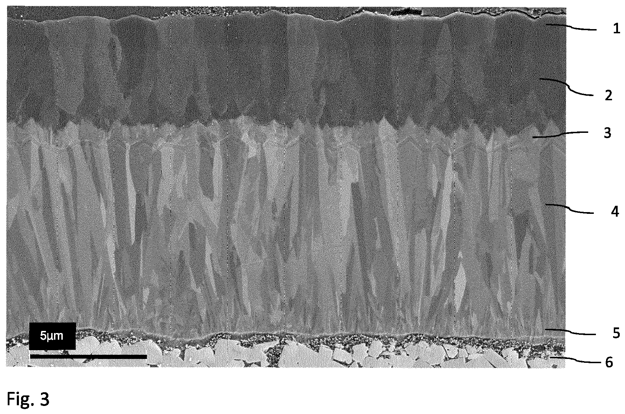

Figures 1-3 show Scanning Electron Microscope (SEM) images of cross sections of sample MS41. Figures 1 is a fractured cross section of the coating, Figure 2 is a close up of the $\alpha$-Al$_2$O$_3$ layers (1,2) shown in Figure 1, and Figure 3 is a polished cross section of the coating. The sample MS41 comprises an outer $\alpha$-Al$_2$O$_3$-single-layer (1), an inner $\alpha$-Al$_2$O$_3$-multilayer (2), bonding layers (3), TiCN layer (4) and a TiN layer (5) deposited on a cemented carbide substrate (6).

DEFINITIONS

The term "cutting tool" is herein intended to denote cutting tools suitable for metal cutting applications such as inserts, end mills or drills. The application areas can for example be turning, milling or drilling in metals such as steel.

METHODS

XRD analysis

In order to investigate the texture or orientation of the layer(s) X-ray diffraction (XRD) was conducted on the flank face using a PANalytical CubiX3 diffractometer equipped with a PIXcel detector. The coated cutting tools were mounted in sample holders to ensure that the flank face of the samples are parallel to the reference surface of the sample holder and also that the flank face is at appropriate height. Cu-K$\alpha$ radiation was used for the measurements, with a voltage of 45 kV and a current of 40 mA. Anti-scatter slit of ½ degree and divergence slit of ¼ degree were used. The diffracted intensity from the coated cutting tool was measured in the range 20° to 140° 2$\theta$, i.e. over an incident angle $\theta$ range from 10 to 70°. The data analysis, including background fitting, Cu-K$\alpha$2 stripping and profile fitting of the data, was done using PANalytical's X'Pert HighScore Plus software. The output (integrated peak areas for the profile fitted curve) from this program was then used to define the coating of the present invention in terms of intensity ratios and/or relations.

Normally a so called thin film correction is to be applied to the integrated peak area data to compensate for differences in intensities due to absorption and different path lengths in layers, but since the TiCO, TiCNO, AlTiCO or AlTiCNO sublayers of the present invention are thin and comprise protrusions the thickness of this layer is not trivial to set and the path length through this layer is complex. The orientation of the $\alpha$-Al$_2$O$_3$-multilayer in combination with the $\alpha$-Al$_2$O$_3$-single-layer is therefore set based on data without thin film correction applied to the extracted integrated peak area intensities for the profile fitted curve. Cu-K$\alpha$2 stripping is however applied to the data before the intensity areas are calculated.

Since possible further layers above the outer $\alpha$-Al$_2$O$_3$-single-layer will affect the X-ray intensities entering the $\alpha$-Al$_2$O$_3$-single-layer and exiting the whole coating, corrections need to be made for these, taken into account the linear absorption coefficient for the respective compound in a layer. Alternatively, a further layer, above the $\alpha$-Al$_2$O$_3$-single-layer can be removed by a method that does not substantially influence the XRD measurement results, e.g. chemical etching.

It is to be noted that peak overlap is a phenomenon that can occur in X-ray diffraction analysis of coatings comprising for example several crystalline layers and/or that are deposited on a substrate comprising crystalline phases, and this has to be considered and compensated for by the skilled person. A peak overlap of peaks from the $\alpha$-Al2O3 layer with peaks from the TiCN layer might influence measurement and needs to be considered. It is also to be noted that for example WC in the substrate can have diffraction peaks close to the relevant peaks of the present invention.

EXAMPLES

Exemplifying embodiments of the present invention will now be disclosed in more detail and compared to reference embodiments. Coated cutting tools (inserts) were manufactured, analyzed and evaluated in cutting tests.

Sample overview

Cemented carbide substrates were manufactured utilizing conventional processes including milling, mixing, spray drying, pressing and sintering. The sintered substrates were CVD coated in a radial CVD reactor of Ionbond Type size 530 capable of housing 10.000 half inch size cutting inserts. The ISO-type geometry of the cemented carbide substrates (inserts) were CNMG-120408-PM. The composition of the cemented carbide was 7.2 wt% Co, 2.9 wt% TaC, 0.5 wt% NbC, 1.9 wt%TiC, 0.4 wt% TiN and the rest WC. An overview of the samples is shown in Table 1.

Table 1 Sample overview

| Sample | Coating layout above TiN+TiCN+bonding layers |
|---|---|
| MS41 | ($\alpha$-Al$_2$O$_3$ + TiCO)$_{26}$+ $\alpha$-single-Al$_2$O$_3$ |
| MS14 | ($\alpha$-Al$_2$O$_3$ + TiCO)$_8$ + $\alpha$-single-Al$_2$O$_3$ |
| MS23 | ($\alpha$-Al$_2$O$_3$ + TiCO)$_{15}$+ $\alpha$-single-Al$_2$O$_3$ |
| S5 | $\alpha$-single-Al$_2$O$_3$ |
| M5 | ($\alpha$-Al$_2$O$_3$ + TiCO)$_{39}$ + one outermost sublayer of $\alpha$-Al$_2$O$_3$ |
| MS-4 | (TiCO+ $\alpha$-Al$_2$O$_3$)$_4$+ $\alpha$-single-Al$_2$O$_3$ |

CVD deposition

A first innermost layer of about 0.4 $\mu$m TiN was deposited on all substrates in a process at 400 mbar and 885 °C. A gas mixture of 48.8 vol% H$_2$, 48.8 vol% N$_2$ and 2.4 vol% TiCl$_4$ was used.

Thereafter an about 6.5 $\mu$m thick TiCN was deposited in two steps, an inner TiCN and an outer TiCN.

The inner TiCN was deposited for 10 minutes at 55 mbar at 885°C in a gas mixture of, 3.0 vol% TiCl$_4$, 0.45 vol% CH$_3$CN, 37.6 vol% N$_2$ and balance H$_2$.

The outer TiCN was deposited at 55 mbar at 885°C in a gas mixture of 7.8 vol% N$_2$, 7.8 vol% HCl, 2.4 vol% TiCl$_4$, 0.65 vol% CH$_3$CN and balance H$_2$.

On top of the MTCVD TiCN layer a 1-1.5 $\mu$m thick bonding layer was deposited at 1000°C by a process consisting of four separate reaction steps.

First a HTCVD TiCN was deposited at 400 mbar, using a gas mixture of 1.5 vol% TiCl$_4$, 3.4 vol% CH$_4$, 1.7% HCl, 25.5 vol% N$_2$ and 67.9 vol% H$_2$.

The three next steps were all deposited at 70 mbar. In the first (TiCNO-1) a gas mixure of 1.5 vol% TiCl$_4$, 0.40 vol% CH$_3$CN, 1.2 vol% CO, 1.2 vol% HCl, 12.0 vol% N$_2$ and balance H$_2$ was used. The next step (TiCNO-2) used a gas mixture of 3.1 vol% $TiCl_4$, 0.63 vol% $CH_3CN$, 4.6 vol% CO, 30.6 vol% $N_2$ and balance $H_2$. In the last bonding layer step (TiN) a gas mixture of 3.2 vol% $TiCl_4$, 32.3% vol% $N_2$ and 64.5 vol% $H_2$ was used.

Prior to the start of the subsequent $Al_2O_3$ nucleation, the bonding layer was oxidized for 4 minutes at 60 mbar in a mixture of 3.7% $CO_2$, 12.5% CO, 30% $N_2$ and 53.8% $H_2$.

On all samples, an $\alpha$-$Al_2O_3$-layer was deposited on top of the bonding layer at 1000°C and 60 mbar in two steps. The first step contained a gas mixture of 1.2 vol% $AlCl_3$, 4.7 vol% $CO_2$, 1.8 vol% HCl and balance $H_2$, and a second step contained a gas mixture of 1.2 vol% AlCl3, 4.7 vol% $CO_2$, 2.9 vol% HCl, 0.58 vol% $H_2S$ and balance $H_2$. On the so-called MS samples (Multi+Single samples) and the M samples (Multi samples) this layer were grown to approximately 0.1 $\mu$m. On the S sample (Single sample) this layer constitute the $\alpha$-$Al_2O_3$-single layer.

An $\alpha$-$Al_2O_3$-multilayer was deposited on the MS samples and the M samples wherein a bonding sublayer of TiCO was alternated with a sublayer of $\alpha$-$Al_2O_3$. The TiCO sublayer was for all examples deposited for 75 seconds. It was deposited at 1000°C and 60 mbar in a gas mixture of 1.7 vol% $TiCl_4$, 3.5 vol% CO, 4.3 vol% $AlCl_3$ and 90.5 vol% $H_2$. The $\alpha$-$Al_2O_3$ sublayer was deposited in two steps using identical process parameters as for the bottom $\alpha$-$Al_2O_3$ layer. The first step was performed for 2.5 minutes and the process time of the second step was about 3 minutes.

One period is equal to the sum of the thickness of one TiCO bonding sublayer and the thickness of one $\alpha$-$Al_2O_3$-sublayer. The measurement of the period in the $\alpha$-$Al_2O_3$-multilayers of the samples was made by dividing the total thickness of the $\alpha$-$Al_2O_3$-multilayer with the number of periods in the layer.

The thicknesses of the layers of the samples were studied in a light optical microscope and are shown on Table 2.

Table 2 Layer thicknesses

| Sample | TiN + TiCN + bonding layer [$\mu$m] | Multi $\alpha$-$Al_2O_3$ [$\mu$m] ($\alpha$-$Al_2O_3$ + TiCO)$_x$ | Period in multi$\alpha$-$Al_2O_3$ [nm] | Single $\alpha$-$Al_2O_3$ [$\mu$m] | Ratio of multilayer to total alumina layer thickness [%] | Total coating thickness [$\mu$m] |
|---|---|---|---|---|---|---|
| MS41 | 8.9 | 3.3 | 127 | 1.3 | 72 | 13.5 |
| MS14 | 9.0 | 1.1 | 138 | 3.8 | 22 | 13.9 |
| MS23 | 8.9 | 2.1 | 140 | 3.0 | 41 | 14.0 |
| S5 | 8.5 | - | - | 5.1 | - | 13.6 |
| M5 | 8.5 | 4.8 | 123 | 0.1 | 98 | 13.4 |
| MS-4 | 8.8 | 0.5 | 125 | 4.2 | 11 | 13.5 |

XRD analyze results

XRD analyses were made as disclosed in the method section above. No thin film correction was applied to the intensity data. The intensities of the peaks 110, 113, 024, 116, 0 0 12 and 0 1 14 originating from $\alpha$-$Al_2O_3$ for the samples are presented in Table 3 with the values normalized such that the intensity of 0 0 12 was set to 100%. No PDF-card is needed for this calculation, it is the relative intensity of the reflections that are studied.

Table 3 XRD intensities originating from $\alpha$-$Al_2O_3$

| Sample | I(110) | I(113) | I(024) | I(116) | I(0 0 12) | I(0 1 14) |
|---|---|---|---|---|---|---|
| MS41 | 62 | 10 | 20 | 12 | 100 | 47 |
| MS14 | 37 | 9 | 23 | 14 | 100 | 60 |
| MS23 | 43 | 8 | 31 | 17 | 100 | 62 |
| S5 | 74 | 5 | 16 | 6 | 100 | 53 |
| M5 | 65 | 4 | 19 | 11 | 100 | 45 |
| MS-4 | 61 | 5 | 16 | 9 | 100 | 48 |

As can be seen in Table 3, all the samples show a very high peak intensity originating from the 0 0 12 planes.

The TiCN layer located between the substrate and the $\alpha$-$Al_2O_3$-layers of the samples were studied in XRD. Since the same CVD deposition parameters were used on all samples, only the TC values from the S5 sample is presented below. Subsequent to thin film correction and correction for absorption in the single $\alpha$-$Al_2O_3$-layer of the data, the TC values were calculated using Harris formula. The TC values are shown in Table 4.

Harris formula:

$$TC(hkl) = \frac{I(hkl)}{I_0(hkl)}\left[\frac{1}{n}\sum_{n=1}^{n}\frac{I(hkl)}{I_0(hkl)}\right]^{-1}$$

where I(hkl) is the measured intensity (integrated area) of the (hkl) reflection, $I_0$(hkl) is the standard intensity according to ICDD's PDF-card No. 42-1489, n is the number of reflections, reflections used in the calculation are (111), (200), (220), (311), (331), (420), (422) and (511).

Table 4 TC values of TiCN layer of sample S5

| h k l | TC(h k l) |
|-------|-----------|
| 2 2 0 | 0.11 |
| 3 1 1 | 2.18 |
| 4 2 2 | 4.02 |

XRD signal from the TiCO sublayers and signals from the TiCN layer is difficult to separate in analyzing the layers since both the TiCO and the TiCN are cubic with similar cell parameters. Before analyzing the TiCN layer the $\alpha$-$Al_2O_3$-multilayers could first be removed by mechanical or chemical means such as etching or polishing..

Cutting tests

The CNMG-120408-PM (P25) cutting tools (i.e the samples) were evaluated in metal cutting tests . A blasting was performed on the rake faces of the coated cutting tools prior to the cutting tests. The blaster slurry used consisted of 20 vol-% alumina in water and an angle of 90 deg. between the rake face of the cutting insert and the direction of the blaster slurry. The pressure of the slurry to the gun was 2.2 bar for all wear tested samples.

The samples were tested in a dry turning test cutting in work piece material Impax Supreme (Ni-Cr-Mo steel of hardness 290-330 HB). Longitudinal turning was applied on said work piece. The following cutting data was used:

Cutting speed, $V_c$: 70 m/min

Feed, $f_n$: 0.7 mm/revolution

Cutting depth, $a_p$: 2 mm

No coolant was applied.

Each insert edge was inspected regularly and the area of flaking on the flank face was measured. The results from the 2 tests 1-2 are shown in Table 5. In test 1 the edges were inspected each 5th second and in test 2 each 10th second. In tests 1 and 2 the 10th measured value of the flaking area is presented.

Table 5 Results

| Sample | Test 1 [mm² flaking area] | Test 2 [mm² flaking area] |
|--------|---------------------------|---------------------------|
| MS41 | 0.01 | 0.07 |
| S5 | 0.15 | 0.19 |
| MS-4 | 0.13 | 0.2 |
| MS14 | 0.22 | 0.19 |
| MS23 | 0.19 | 0.19 |
| M5 | 0.05 | 0.21 |

From the tests it was concluded that the samples MS41 were the samples that did show the highest resistance to flaking.

While the invention has been described in connection with various exemplary embodiments, it is to be understood that the invention is not to be limited to the disclosed exemplary embodiments, on the contrary, it is intended to cover various modifications and equivalent arrangements within the appended claims. Furthermore, it should be recognized that any disclosed form or embodiment of the invention may be incorporated in any other disclosed or described or suggested form or embodiment as a general matter of design choice. It is the intention, therefore, to be limited only as indicated by the scope of the appended claims appended hereto.

**Claims**

1. A coated cutting tool comprising a substrate and a coating, wherein the coating comprises
   an inner $\alpha$-Al$_2$O$_3$-multilayer and an outer $\alpha$-Al$_2$O$_3$-single-layer,
   wherein the thickness of the outer $\alpha$-Al$_2$O$_3$-single-layer is 1-8 $\mu$m, preferably 1-3 $\mu$m, and
   wherein the thickness of the inner $\alpha$-Al$_2$O$_3$-multilayer is 50% to 80% of the sum of the thickness of the inner $\alpha$-Al$_2$O$_3$-multilayer and the thickness of the outer $\alpha$-Al$_2$O$_3$-single-layer,
   and wherein said $\alpha$-Al$_2$O$_3$-multilayer consist of alternating sublayers of $\alpha$-Al$_2$O$_3$ and sublayers of TiCO, TiCNO, AlTiCO or AlTiCNO, said inner $\alpha$-Al$_2$O$_3$-multilayer comprises at least 8 sublayers of $\alpha$-Al$_2$O$_3$.

2. The coated cutting tool according to claim 1, wherein the inner $\alpha$-Al$_2$O$_3$-multilayer is adjacent to the outer $\alpha$-Al$_2$O$_3$-single-layer.

3. The coated cutting tool according to claim 1 or 2, wherein the sum of the thickness of the inner $\alpha$-Al$_2$O$_3$-multilayer and the outer $\alpha$-Al$_2$O$_3$-single-layer is 2-16 $\mu$m, preferably 3-8 $\mu$m, most preferably 4-6 $\mu$m.

4. The coated cutting tool according to any of the preceding claims, wherein a period in the inner $\alpha$-Al$_2$O$_3$-multilayer is 50-900 nm, preferably 70-300 nm, more preferably 70-150 nm, wherein one period include one sublayer of $\alpha$-Al$_2$O$_3$ and one sublayer of TiCO, TiCNO, AlTiCO or AlTiCNO.

5. The coated cutting tool according to any of the preceding claims wherein the thickness of the inner $\alpha$-Al$_2$O$_3$-multilayer is 50-80%, preferably 65-75% of the sum of the thickness of the inner $\alpha$-Al$_2$O$_3$-multilayer and the thickness of the outer $\alpha$-Al$_2$O$_3$-single-layer.

6. The coated cutting tool according to any of the preceding claims, wherein the inner $\alpha$-Al$_2$O$_3$-multilayer in combination with the outer $\alpha$-Al$_2$O$_3$-single-layer exhibits an XRD diffraction over a $\theta$-2$\theta$ scan of 20°-140°, wherein the intensity of the 0 0 12 diffraction peak (peak area), I(0 0 12), to the intensities of the 113 diffraction peak (peak area), I(113), the 1 1 6 diffraction peak (peak area), I(116), and the 0 2 4 diffraction peak (peak area), I(0 2 4), is I(0012)/I(113) > 1, I(0012)/I(116) > 1 and I(0012)/I(024) > 1.

7. The coated cutting tool according to claim 6, wherein intensity of the 0 114 diffraction peak (peak area), I(0114), to the intensity of the 0 0 12 diffraction peak (peak area), I(0 012), is I(0114)/I(0012) < 2.

8. The coated cutting tool according to claim 6 or 7, wherein the relation between the intensity of the 110 diffraction peak (peak area), I(110), and the intensities of the 11 3 diffraction peak (peak area), I(113), and the 024 diffraction peak (peak area), I(02 4), is
   I(110) > each of I(113) and I(024).

9. The coated cutting tool according to any of claims 6-8, wherein the relation between the intensity of the 0012 diffraction peak (peak area), I(0012), and the intensity of the 110 diffraction peak (peak area), I(110), is
   I(0012) > I(110).

10. The coated cutting tool according to any of the preceding claims, wherein the coated cutting tool comprises at least one layer of TiC, TiN, TiAlN or TiCN located between the substrate and the inner $\alpha$-Al$_2$O$_3$-multilayer, preferably TiCN.

11. The coated cutting tool according to claim 10, wherein the thickness of the TiC, TiN, TiAlN or TiCN layer is 2-15 $\mu$m, preferably 3-13 $\mu$m.

12. The coated cutting tool according to claim 10 or 11, wherein the coated cutting tool comprises a TiCN layer that exhibits an X-ray diffraction pattern, as measured using CuK$\alpha$ radiation and $\theta$-2$\theta$ scan, wherein the TC(hkl) is defined according to Harris formula:

$$TC(hkl) = \frac{I(hkl)}{I_0(hkl)} \left[ \frac{1}{n} \sum_{n=1}^{n} \frac{I(hkl)}{I_0(hkl)} \right]^{-1}$$

where I(hkl) is the measured intensity (integrated area) of the (hkl) reflection, $I_0$(hkl) is the standard intensity according to ICDD's PDF-card No. 42-1489, n is the number of reflections, reflections used in the calculation are (111), (200), (220), (311), (331), (420), (422) and (511), wherein TC(331)+TC(422) > 5, preferably > 6.

13. The coated cutting tool according to any of the preceding claims, wherein the outermost layer of the coating is said outer $\alpha$-Al$_2$O$_3$-single-layer.

14. The coated cutting tool according to any of the preceding claims, wherein the substrate is of cemented carbide, cermet, ceramic, high speed steel or cBN.

15. The coated cutting tool according to any of the preceding claims, wherein the substrate is of cemented carbide comprising 3-14 wt% Co and more than 50 wt% WC.

Fig. 1

Fig. 2

Fig. 3

Europäisches
Patentamt

European
Patent Office

Office européen
des brevets

# EUROPEAN SEARCH REPORT

**Application Number**

EP 18 21 4848

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2018/224487 A1 (SANDVIK INTELLECTUAL PROPERTY [SE])<br>13 December 2018 (2018-12-13)<br>* page 11, lines 16-24; claims 1-15 *<br>----- | 1-15 | INV.<br>C23C28/04<br>C23C16/30<br>C23C16/34<br>C23C16/36 |
| X | EP 1 980 649 A1 (ISCAR LTD [IL])<br>15 October 2008 (2008-10-15)<br>* claims 1-27; example 1; table 1 *<br>----- | 1-5,10, 11,13-15 | C23C16/40<br>C23C28/00<br>C23C30/00<br>C23C16/02 |
| A | EP 1 323 847 A2 (SECO TOOLS AB [SE])<br>2 July 2003 (2003-07-02)<br>* claims 1-24 *<br>----- | 1-15 | |
| A | EP 1 455 003 A2 (SANDVIK AB [SE])<br>8 September 2004 (2004-09-08)<br>* claims 1-9 *<br>----- | 1-15 | |

**TECHNICAL FIELDS SEARCHED (IPC)**

C23C

The present search report has been drawn up for all claims

| Place of search | Date of completion of the search | Examiner |
|---|---|---|
| The Hague | 8 February 2019 | Chalaftris, Georgios |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

.......................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 18 21 4848

This annex lists the patent family members relating to the patent documents cited in the above-mentioned European search report.
The members are as contained in the European Patent Office EDP file on
The European Patent Office is in no way liable for these particulars which are merely given for the purpose of information.

08-02-2019

| Patent document cited in search report | | Publication date | Patent family member(s) | | Publication date |
|---|---|---|---|---|---|
| WO 2018224487 | A1 | 13-12-2018 | NONE | | |
| EP 1980649 | A1 | 15-10-2008 | AT | 478172 T | 15-09-2010 |
| | | | BR | PI0809167 A2 | 16-09-2014 |
| | | | CN | 101652502 A | 17-02-2010 |
| | | | EP | 1980649 A1 | 15-10-2008 |
| | | | IL | 182344 A | 31-07-2011 |
| | | | JP | 5269066 B2 | 21-08-2013 |
| | | | JP | 2010523351 A | 15-07-2010 |
| | | | KR | 20100014705 A | 10-02-2010 |
| | | | RU | 2009136033 A | 20-06-2011 |
| | | | TW | 200841978 A | 01-11-2008 |
| | | | US | 2008240876 A1 | 02-10-2008 |
| | | | WO | 2008120185 A1 | 09-10-2008 |
| EP 1323847 | A2 | 02-07-2003 | CN | 1432663 A | 30-07-2003 |
| | | | EP | 1323847 A2 | 02-07-2003 |
| | | | JP | 2003213455 A | 30-07-2003 |
| | | | KR | 20030057435 A | 04-07-2003 |
| | | | US | 2003143384 A1 | 31-07-2003 |
| | | | US | 2004110040 A1 | 10-06-2004 |
| EP 1455003 | A2 | 08-09-2004 | CN | 1517450 A | 04-08-2004 |
| | | | EP | 1455003 A2 | 08-09-2004 |
| | | | JP | 5529771 B2 | 25-06-2014 |
| | | | JP | 2004223711 A | 12-08-2004 |
| | | | JP | 2011067948 A | 07-04-2011 |
| | | | KR | 20040068476 A | 31-07-2004 |
| | | | SE | 0300175 A | 25-07-2004 |
| | | | US | 2004180241 A1 | 16-09-2004 |

EPO FORM P0459

For more details about this annex : see Official Journal of the European Patent Office, No. 12/82